# EUROPÄISCHE PATENTSCHRIFT

(11) **EP 2 625 545 B1**
(45) Veröffentlichungstag und Bekanntmachung des Hinweises auf die Patenterteilung: **20.06.2018**
(21) Anmeldenummer: 11748334.7
(22) Anmeldetag: 08.08.2011
(51) Int. Cl.: G01S 17/08, G01S 7/481, G01S 7/483

(54) **OPTISCHE ABSCHIRM-VORRICHTUNG ZUM TRENNEN VON OPTISCHEN PFADEN**
OPTICAL SHIELDING DEVICE FOR SEPARATING OPTICAL PATHS
DISPOSITIF D'ÉCRAN OPTIQUE POUR LA SÉPARATION DE PARCOURS OPTIQUES

(30) Priorität: 04.10.2010 DE 102010041937
(43) Veröffentlichungstag der Anmeldung: 14.08.2013
(73) Patentinhaber: Robert Bosch GmbH, 70442 Stuttgart (DE)
(72) Erfinder: EISELE, Andreas, 70771 Leinfelden-Echterdingen (DE); WOLST, Oliver, Singapore 573943 (SG); SKULTETY-BETZ, Uwe, 70771 Leinfelden-Echterdingen (DE); SCHMIDTKE, Bernd, 71229 Leonberg (DE)
(86) Internationale Anmeldenummer: PCT/EP2011/063620
(87) Internationale Veröffentlichungsnummer: WO 2012/045503

(56) Entgegenhaltungen:
- EP-A1- 1 619 469
- GB-A- 2 122 835
- US-A- 5 798 831
- US-A1- 2002 084 432
- US-A1- 2005 139 750
- US-A1- 2007 272 882
- US-A1- 2011 076 001

## Beschreibung

### Stand der Technik

Bei optischen Messgeräten kann es oft wichtig sein, zu einer eigentlichen Messung eine Referenzmessung durchzuführen. Die Referenzmessung kann zu Kalibrierzwecken des Messgeräts verwendet werden.

Zur Durchführung der Referenzmessung können beispielsweise Gerät-interne Referenzstrecken vorgesehen sein. Aus DE 10 2005 037 253 A1 ist z.B. ein Entfernungsmessgerät mit Referenzstrecke bekannt. Weitere Ausführungen zu Entfernungsmessgeräten, in denen eine Geräte-interne Referenzstrecke zur Kalibrierung des Messgeräts verwendet wird, finden sich beispielsweise in EP 1 619 469 A1, US 5,798,831 A, US 2007/272882 A1 und GB 2 122 835 A.

Die Referenzmessung kann vor, nach oder gleichzeitig mit der eigentlichen Messung durchgeführt werden. Bei gleichzeitiger Messung kann Messstrahlung an den Empfänger für Referenzstrahlung und Referenzstrahlung an den Empfänger für Messstrahlung gelangen. Dieses Übersprechen verringert die Messgenauigkeit erheblich. Das Übersprechen kann umso intensiver sein, je näher die Empfänger für Referenz- und Messstrahlung beieinander angeordnet sind. Die Dokumente US 2002/084432 A1, US 2011/076001 A1 und US 2005/139750 A1 beschreiben Sensorelemente mit mehreren Detektionsbereichen, die von einer optische Abschirm-Vorrichtung getrennt sind.

### Offenbarung der Erfindung

Es kann daher ein Bedarf an einer Sensoreinheit und einem Entfernungsmessgerät bestehen, die eine gute optische Isolation von eng benachbarten optischen Pfaden ermöglicht.

Diese Aufgabe kann durch den Gegenstand der vorliegenden Erfindung gemäß den unabhängigen Ansprüchen gelöst werden. Vorteilhafte Ausführungsformen der vorliegenden Erfindung sind in den abhängigen Ansprüchen beschrieben.

Im Folgenden werden Merkmale, Einzelheiten und mögliche Vorteile einer Vorrichtung gemäß Ausführungsformen der Erfindung im Detail diskutiert.

Gemäß einem ersten Aspekt der Erfindung wird eine Sensoreinheit zum Detektieren von Referenz- und Messstrahlung für ein Entfernungsmessgerät vorgestellt. Die Sensoreinheit weist ein Sensorelement und eine optische Abschirm-Vorrichtung auf. Das Sensorelement weist einen ersten Detektionsbereich zum Detektieren von Messstrahlung und einen zweiten Detektionsbereich zum Detektieren von Referenzstrahlung auf. Die optische Abschirm-Vorrichtung ist in Bezug auf das Sensorelement positioniert und fixiert und trennt den ersten und den zweiten Detektionsbereich optisch voneinander. Die optische Abschirm-Vorrichtung weist ferner eine erste Ausnehmung und eine zweite Ausnehmung auf, die durchlässig für die optische Strahlung eines ersten Wellenlängenbereichs sind.

Das Sensorelement kann dabei als Chip- oder Chip-Package ausgeführt sein. Ein Chip-Package kann z.B. einen Halbleiterchip mit einem Rahmen oder einer Keramikstruktur aufweisen. Ferner kann ein Chip-Package einen Chip an einer Glasplatte aufweisen. Der erste und zweite Detektionsbereich bzw. die Empfänger für Referenz- und Messstrahlung sind nahe beieinander angeordnet. Z.B. sind sie in einem gemeinsamen Package oder monolithisch auf einem Material, z.B. einem Halbleitermaterial, integriert.

Die optische Abschirm-Vorrichtung (1) weist zwei Ausnehmungen auf, die durchlässig für die optische Strahlung des ersten Wellenlängenbereichs sind. Durch die Ausnehmung können die Mess- und die Referenzstrahlung die Sensoroberfläche an den dafür im Sensor vorgesehenen Detektionsbereichen erreichen. Die erste Ausnehmung kann für die Messstrahlung und die zweite Ausnehmung für die Referenzstrahlung vorgesehen sein. Die Ausnehmung kann eine Öffnung darstellen. Alternativ kann die Ausnehmung einen Filter aufweisen, der selektiv bestimmte Wellenlängen bzw. Wellenlängenbereiche durchlässt. Die erste Ausnehmung kann derart auf der optischen Abschirm-Vorrichtung und in Bezug auf das Sensorelement angeordnet sein, dass optische Strahlung, die die erste Ausnehmung z.B. senkrecht passiert auf den ersten Detektionsbereich trifft. Die zweite Ausnehmung kann ferner derart angeordnet sein, dass optische Strahlung, die die zweite Ausnehmung z.B. senkrecht passiert auf den zweiten Detektionsbereich trifft.

Die optische Strahlung des ersten Wellenlängenbereichs kann z.B. sichtbares, Infrarot- oder Ultraviolettlicht sein. Der erste Wellenlängenbereich kann z.B. der Bereich der Messstrahlung sein. Der erste Wellenlängenbereich kann alle Wellenlängen oder etwa ±100 nm um eine bestimmte Wellenlänge umfassen oder alternativ genau einer Wellenlänge entsprechen. Z.B. kommt ein Halbleiterlaser mit einer Wellenlänge von 635nm oder 650nm zu Einsatz.

Die optische Abschirm-Vorrichtung kann z.B. als eine Kappe aus Kunststoff über dem Sensorelement ausgestaltet sein. Durch die Ausnehmungen bzw. Öffnungen in der optischen Abschirm-Vorrichtung kann Mess- und Referenzstrahlung auf die jeweiligen Detektionsbereiche treffen. Die optische Abschirm-Vorrichtung kann das Sensorelement z.B. von seitlich einfallendem Licht schützen. Ferner trennt die optische Abschirm-Vorrichtung z.B. mittels eines Stegs oder einer Lippe die Detektionsbereiche optisch voneinander.

Das Sensorelement kann an einem Trägerelement wie z.B. einer Leiterplatte bzw. Platine fixiert sein. Die optische Abschirm-Vorrichtung, die über dem Sensorelement angeordnet werden kann, kann z.B. ebenfalls an dem Trägerelement fixiert werden. Die Fixierung kann z.B. mittels einer Verklebung oder Verrastung erfolgen. Die optische Abschirm-Vorrichtung ist in Bezug auf die Position des Sensorelements auf dem Trägerelement fixiert. Ferner kann die optische Abschirm-Vorrichtung ausgeführt sein sich am Sensorelement auszurichten und zu positionieren.

Anders ausgedrückt basiert die Idee der vorliegenden Erfindung darauf, eine optische Trennung zwischen einer Referenz- und einer Messstrahlung auf einem Sensorelement vorzunehmen. Dies kann insbesondere wichtig sein, wenn Referenz- und Messstrahlungs-Empfänger auf einem Siliziumchip integriert sind, was eine hochpositionsgenaue Trennung auf kurzen Distanzen mit einem möglichst minimalen Übersprechen notwendig macht.

Die Integration der Empfänger bzw. Detektionsbereiche für Referenz- und Messstrahlung auf einem Sensorelement trägt dazu bei Produktionskosten einzusparen. Ferner kann dank der optischen Abschirm-Vorrichtung trotz geringer Abstände zwischen Referenz- und Messstrahlungs-Detektor eine optische Trennung gewährleistet und damit die Messgenauigkeit erhöht werden.

Die erfindungsgemäße Sensoreinheit kann insbesondere bei Packaging-Technologien eingesetzt werden, die geringe Toleranzen zwischen der Befestigungs-Position des Chips (auch als "Die" bezeichnet) und den Außenkanten des Packages aufweisen.

Die optische Abschirm-Vorrichtung kann z.B. in ihren Abmessungen in der Größenordnung des Sensorelements z.B. 2,5 x 2,5 mm liegen. Sie kann z.B. in optischen Messgeräten, insbesondere in Abstandsmessgeräten, eingesetzt werden.

Gemäß einem Ausführungsbeispiel der Erfindung weist die optische Abschirm-Vorrichtung eine erste Anlagefläche auf, die ausgestaltet ist, eine Ausrichtung der optischen Abschirm-Vorrichtung in einer Ebene parallel zur Oberfläche des Sensorelements zu bewirken. Hierzu kann die erste Anlagefläche als eine seitliche Anschlagfläche ausgeführt sein. Die Ausrichtung der optischen Abschirm-Vorrichtung ermöglicht eine präzise Positionierung unabhängig von Fertigungstoleranzen weiterer Elemente wie z.B. der Leiterplatte und trotz der geringen Abmessungen der Einzelteile.

Gemäß einem weiteren Ausführungsbeispiel weist die optische Abschirm-Vorrichtung eine zweite Anlagefläche auf, die ausgestaltet ist, eine Ausrichtung der optischen Abschirm-Vorrichtung in einer Ebene senkrecht zur Oberfläche des Sensorelements zu bewirken. Die zweite Anlagefläche kann eine zur Oberfläche des Sensorelements parallele Fläche sein. Z.B. ist die zweite Anlagefläche an einer Lippe bzw. einem Steg der optischen Abschirm-Vorrichtung zwischen dem ersten und zweiten Detektionsbereich ausgeführt. Zusätzlich oder alternativ können weitere zweite Anlageflächen an den Rändern der optischen Abschirm-Vorrichtung vorgesehen sein. Die zweite Anlagefläche kann oben auf dem Sensorelement aufliegen.

Gemäß einem weiteren Ausführungsbeispiel weist die optische Abschirm-Vorrichtung eine Hard-Komponente und eine Soft-Komponente auf, die undurchlässig für optische Strahlung des ersten Wellenlängenbereichs sind. Dabei ist die Soft-Komponente an einer sensorzugewandten Seite der optischen Abschirm-Vorrichtung angeordnet und deformierbar ausgeführt.

Die Hard- und die Soft-Komponente können z.B. aus unterschiedlichen Materialien, die z.B. eine unterschiedliche Härte und eine unterschiedliche Dichte aufweisen, hergestellt sein. Die Hard-Komponente kann z.B. als ein formstabiler Rahmen ausgestaltet sein, der eine zum Sensorelement komplementäre Geometrie aufweist und an ihm ausgerichtet werden kann. Die Hard-Komponente kann ferner z.B. weniger deformierbar als die Soft-Komponente ausgeführt sein.

Die Soft-Komponente kann z.B. als weiche parabolisch geformte Lippe bzw. Steg, z.B. aus Gummi oder ähnlichem elastischen Material, ausgeführt sein. Die Soft-Komponente kann zwischen dem ersten und dem zweiten Detektionsbereich angeordnet sein und auf diese Weise die optischen Pfade von Referenz- und Messstrahlung trennen.

Die Soft-Komponente ist unter Krafteinwirkung deformierbar, so dass im zusammengebauten Zustand von optischer Abschirm-Vorrichtung und Sensorelement ein dichtes Anliegen der optischen Abschirm-Vorrichtung an der Oberfläche des Sensorelements ermöglicht ist. Hierzu kann die Soft-Komponente z.B. in einem nicht deformierten Zustand in einer zum Sensorelement senkrechten Ebene eine zweite Anlagefläche der Hard-Komponente in Richtung zum Sensorelement hin überragen.

Die Undurchlässigkeit der Hard- und der Soft-Komponente für optische Strahlung eines ersten Wellenlängenbereichs kann bedeuten, dass diese eine optische Dämpfung bewirken. Z.B. liegt die Transmission durch die Hard- und Softkomponente unter 0,1 %, insbesondere unter 0,01 % und bevorzugter weise unter 0,001 % der einfallenden Strahlung.

Die Hard-Komponente kann die erste und die zweite Anlagefläche aufweisen. Die zweite Anlagefläche kann die optische Abschirm-Vorrichtung umranden und eine als zur Oberfläche des Sensorelements parallele Ebene ausgeführt sein. Alternativ oder zusätzlich kann die zweite Anlagefläche an der Soft-Komponente ausgeführt sein.

Die Soft-Komponente kann, sicher stellen, dass trotz Form- und Fertiungstoleranzen die optische Abschirm-Vorrichtung formschlüssig auf der Sensorelementoberfläche liegt und gleichzeitig der Krafteintrag in das Sensorelement auf ein definiertes Maß begrenzt bleibt, bzw. minimiert werden kann. Der maximale Krafteintrag kann unter Berücksichtigung o.g. Toleranzen über eine Shore-Härte der Soft-Komponente eingestellt werden. Dadurch, dass die Glattheit der Glasoberfläche auf die Soft-Komponente übertragen wird, wird die diffuse Streuung von Licht, welches von der Chipoberfläche reflektiert wird, minimiert. Ferner trägt eine Hard-Komponente, welche z.B. als hartes Formteil die Positionsgenauigkeit und mechanische Stabilität gewährleistet und sich vorzugsweise formschlüssig am Sensorelement ausrichtet, zur optischen Trennung der Sensorelementoberfläche bei.

Die Ausgestaltung der optischen Abschirm-Vorrichtung ist besonders vorteilhaft, da beispielsweise Fertigungstoleranzen durch die Soft-Komponente ausgeglichen werden können. Ferner wird eine hohe Positionsgenauigkeit der optischen Abschirm-Vorrichtung durch die direkte Ausrichtung der optischen Abschirm-Vorrichtung mittels der Anlageflächen direkt am Sensorelement erreicht. Nach einem konventionellen System müssen wesentlich höhere Toleranzen berücksichtigt werden, da zunächst die Fertigungstoleranz eines Optikträgers berücksichtigt werden muss. Ferner muss die Positionsgenauigkeit, z.B. die Bohrungen auf der Leiterplatte, für die Befestigung des Optikträgers berücksichtigt werden. Des Weiteren muss die Positionsgenauigkeit von elektrischen Leiterbahnen auf der Leiterplatte und die Positionsgenauigkeit des Sensorelements auf den Leiterbahnen berücksichtigt werden. Demgegenüber müssen bei der vorliegenden Erfindung lediglich die Fertigungstoleranzen der optischen Abschirm-Vorrichtung berücksichtigt werden, da diese direkt am Sensorelement angeordnet wird.

Gemäß einem weiteren Ausführungsbeispiel der Erfindung weist die SoftKomponente und die Hard-Komponente ein im ersten Wellenlängenbereich absorbierendes Material auf. Das absorbierende Material kann z.B. ein mattschwarzes Material sein. Die Hard- und die Soft-Komponente können das gleiche absorbierende Material oder unterschiedliche absorbierende Materialien aufweisen. Ferner kann die Hard- und/oder die Soft-Komponente komplett aus dem absorbierenden Material bestehen. Alternativ kann die Hard- und/oder SoftKomponente eine absorbierende Oberflächenbeschichtung aufweisen, die die Streuung und Reflexion der Mess- und Referenzstrahlung reduziert.

Ferner kann die optische Abschirm-Vorrichtung eine Beschichtung aufweisen, die vor hoch- oder niedrig-frequenter elektromagnetischer Strahlung z.B. im hohen MHz oder im niedrigen GHz Bereich abschirmt. Beispielsweise kann die Beschichtung ein elektrisch leitendes Material, wie z.B. ein leitendes Metall, aufweisen. Dadurch können elektromagnetische Verträglichkeitsprobleme (EMV) verhindert werden, die z.B. durch die im Chip auftretenden hohen Frequenzen verursacht werden können. Zusätzlich können an der optischen Abschirm-Vorrichtung hierzu Abschirmbleche angeordnet sein.

Gemäß einem weiteren Ausführungsbeispiel weist die Soft- Komponente eine erste geometrische Struktur auf, die ausgeführt ist, Streustrahlung von einer Sensoroberfläche abzulenken. Alternativ oder zusätzlich weist die Hard-Komponente eine zweite geometrische Struktur auf, die ausgeführt ist, Streustrahlung von der Sensoroberfläche abzulenken. Die erste geometrische Struktur und die zweite geometrische Struktur können gleich oder unterschiedlich ausgeführt sein. Streustrahlung kann dabei z.B. Strahlung bezeichnen, die nicht senkrecht auf eine Sensoroberfläche fällt. Ferner kann Streustrahlung Referenzstrahlung sein, die auf die zur Detektion von Messstrahlung vorgesehene Detektoroberfläche fällt. Ferner kann Streustrahlung Messstrahlung sein, die auf die zur Detektion von Referenzstrahlung vorgesehene Detektoroberfläche fällt. Die geometrische Struktur kann beispielsweise eine Lichtfalle ("beam dump") sein. Die erste geometrische Struktur und die zweite geometrische Struktur sind so ausgeführt, dass möglichst wenig Streulicht auf die Detektionsfelder der Sensorelementoberfläche fällt. Hierzu kann das Licht in der geometrischen Struktur so reflektiert werden, dass es die optische Abschirm-Vorrichtung wieder verlässt.

Ferner kann auf die Oberfläche des Sensorelements, insbesondere auf eine Glasplatte, eine Beschichtung aufgebracht sein die dazu dient optisches Übersprechen innerhalb des Sensorelements zwischen einem ersten und einem zweiten Detektionsbereich zu verringern. Dies kann insbesondere dadurch erreicht werden, dass die Beschichtung einen Brechungsindex gleicher Größenordnung wie die Oberfläche des Sensorelements aufweist oder die Beschichtung als Anti-Reflection-Coating ausgeführt ist. Beispielsweise ist bei einer Sensoroberfläche aus Glas, eine Beschichtung mit einem Brechungsindex n=1.4 bis 1.6, insbesondere n=1.5 vorteilhaft. Die Beschichtung kann in einem ersten Wellenlängenbereich absorbierend ausgeführt sein. Alternativ kann das Material der Soft- oder Hardkomponente einen der Oberfläche des Sensorelements ähnlichen Brechungsindex aufweisen. Ferner kann die Oberfläche des Sensorelements strukturiert sein, um ein optisches Übersprechen zu minimieren.

Gemäß einem weiteren Ausführungsbeispiel der Erfindung ist die Soft-Komponente einstückig mit der Hard-Komponente ausgeführt. Beispielsweise können die beiden Komponenten als Spritzgussteil insbesondere als Zweikomponentenspritzgussteil (2K-Mould) evtl. aus Kunststoff ausgeführt sein. Alternativ kann die Soft- und die Hard-Komponente aus zwei Teilen bestehen, die beispielsweise gesteckt, geklebt oder verzahnt werden.

Gemäß einem weiteren Ausführungsbeispiel der Erfindung weist die Sensoreinheit ferner ein Trägerelement auf an dem das Sensorelement fixiert ist. An der optischen Abschirm-Vorrichtung ist ferner ein Befestigungselement angeordnet, welches ausgestaltet ist, derart mit dem Trägerelement einzugreifen, dass eine formschlüssige Verbindung zwischen einer Oberfläche des Sensorelements und der optischen Abschirm-Vorrichtung entsteht.

Das Trägerelement ist dabei z.B. als Leiterplatte oder Platine ausgeführt, an der z.B. der Chip angeordnet ist. Das Befestigungselement kann z.B. als ein Schnapphaken ausgeführt sein. Beispielsweise kann das Befestigungselement einstückig mit der Hard-Komponente ausgeführt sein. Das Befestigungselement kann mit einem Einrastelement am Trägerelement zusammenwirken. Das Zusammenwirken des Befestigungselements mit einem Einrastelement kann bewirken, dass die Soft-Komponente der optischen Abschirm-Vorrichtung an die Sensorelementoberfläche gedrückt wird. Hierzu kann das Befestigungselement z.B. elastisch ausgeführt sein.

Gemäß einem weiteren Ausführungsbeispiel der Erfindung weist die optische Abschirm-Vorrichtung ein Schnittstellenelement auf, das ausgestaltet ist, ein Aufsatzelement mit der optischen Abschirm-Vorrichtung zu verbinden. Das Schnittstellenelement kann z.B. eine Führung und/oder eine Befestigung für das Aufsatzelement beinhalten. Das Aufsatzelement kann ebenfalls zur Trennung der Mess- und Referenzstrahlung dienen. Allerdings kann das Aufsatzelement höhere Fertigungstoleranzen u.a. aufgrund des größeren Abstands zum Sensorelement aufweisen. Das Aufsatzelement kann z.B. durch Kleben, Stecken bzw. einen Form- oder Kraftschluss am Schnittstellenelement befestigt werden.

Gemäß einem Ausführungsbeispiel der Erfindung weist die Sensoreinheit eine Sendeeinrichtung wie z.B. eine Laserdiode zum Aussenden von Messstrahlung und Referenzstrahlung auf. Die Sendeeinrichtung ist direkt auf dem Sensorelement angeordnet. Das heißt, die Sendeeinrichtung befindet sich zwischen Sensorelement und der optischen Abschirm-Vorrichtung, so dass die Messstrahlung die Sensoreinheit verlassen kann und zu ihr durch eine Ausnehmung in der optischen Abschirm-Vorrichtung zurückkehren kann. Die Referenzstrahlung kann entlang einer Referenzstrecke innerhalb der Sensoreinheit verlaufen und z.B., ohne die optische Abschirm-Vorrichtung zu verlassen, auf den zweiten Detektionsbereich des Sensorelements treffen.

Gemäß einem zweiten Aspekt der vorliegenden Erfindung wird ein Entfernungsmessgerät zum Bestimmen einer Entfernung, welches die oben beschriebene Abschirm-Vorrichtung aufweist, beschrieben.

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.
- Fig. 1: zeigt einen seitlichen Querschnitt durch eine Sensoreinheit gemäß einem Ausführungsbeispiel der Erfindung
- Fig. 2: zeigt einen seitlichen Querschnitt durch eine optische Abschirm-Vorrichtung gemäß einem Ausführungsbeispiel der Erfindung
- Fig. 3: zeigt einen seitlichen Querschnitt durch eine Sensoreinheit mit zusätzlichen Soft-Komponenten
- Fig. 4: zeigt einen seitlichen Querschnitt durch eine optische Abschirm-Vorrichtung mit absorbierender Beschichtung und absorbierenden geometrischen Strukturen
- Fig. 5: zeigt in einem seitlichen Querschnitt die Justage der optischen Abschirm-Vorrichtung an dem Sensorelement in z-Richtung
- Fig. 6: zeigt in einem seitlichen Querschnitt die Justage der optischen Abschirm-Vorrichtung an dem Sensorelement in der x-y-Ebene
- Fig. 7: zeigt eine Draufsicht auf eine optische Abschirm-Vorrichtung an einer Leiterplatte
- Fig. 8: zeigt einen seitlichen Querschnitt durch eine Sensoreinheit mit einem Schnittstellenelement
- Fig. 9: zeigt in einem seitlichen Querschnitt durch eine Sensoreinheit die mechanische Fixierung der optischen Abschirm-Vorrichtung mittels Schnapphaken
- Fig. 10: zeigt in einem seitlichen Querschnitt durch eine Sensoreinheit die mechanische Fixierung der optischen Abschirm-Vorrichtung mittels Verkleben
- Fig. 11: zeigt mögliche Ausgestaltungen des Sensorelements
- Fig. 12: zeigt einen seitlichen Querschnitt durch eine Sensoreinheit mit einer an der Leiterplatte angeordneten Sendeeinrichtung
- Fig. 13: zeigt einen seitlichen Querschnitt durch eine Sensoreinheit mit einer zwischen Sensorelement und optischer Abschirm-Vorrichtung angeordneten Sendeeinrichtung

Alle Figuren sind lediglich schematische Darstellungen erfindungsgemäßer Vorrichtungen bzw. ihrer Bestandteile gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

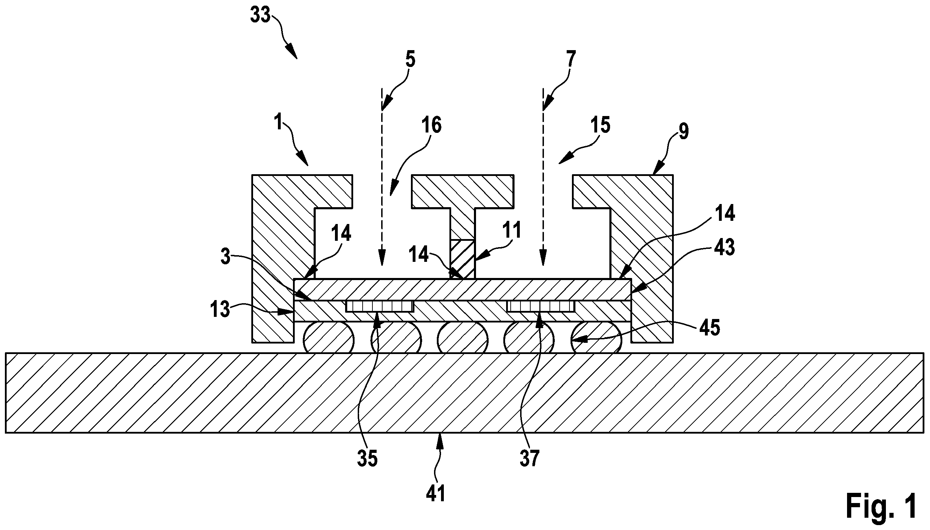

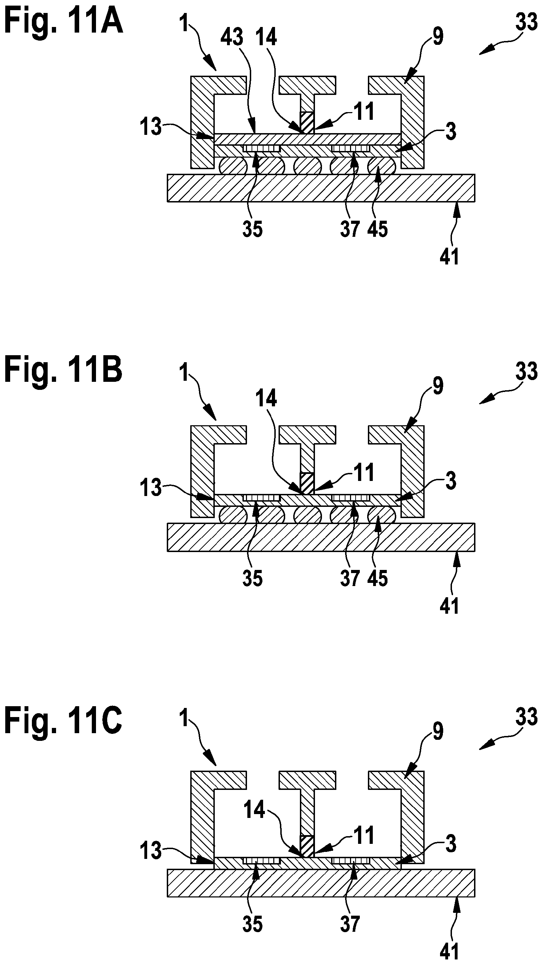

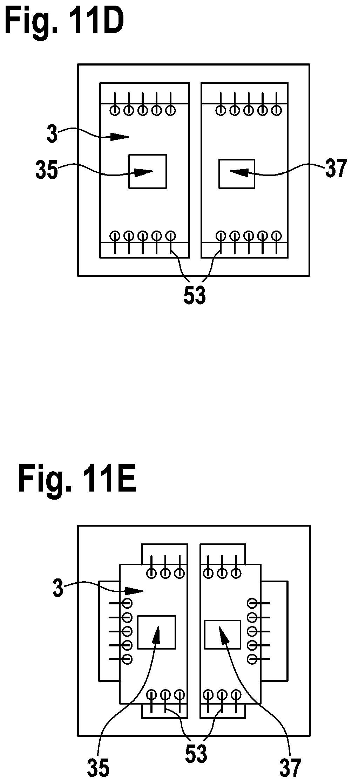

In Fig. 1 ist schematisch ein seitlicher Querschnitt durch eine Sensoreinheit 33 dargestellt. Die Sensoreinheit 33 weist ein Sensorelement 3 und eine optische Abschirm-Vorrichtung 1 auf. Das Sensorelement 3 kann z.B. ein auf einem Trägerelement 41 wie z.B. einer Leiterplatte 41 angeordneter Chip mit einem ersten Detektionsbereich 35 für Messstrahlung 5 und einem zweiten Detektionsbereich 37 für Referenzstrahlung 7 sein. Das Sensorelement 3 kann ferner ein Chip-Package mit einer Glasplatte 43 sein, die den Chip und insbesondere die Detektionsbereiche 35, 37 abdeckt. Das Sensorelement 3 kann wie in Fig. 11 dargestellt, unterschiedlich an der Leiterplatte 41 befestigt sein. Wie in Fig. 11a gezeigt, kann das Sensorelement 3 eine Glasplatte 43 aufweisen und auf die Leiterplatte 41 mittels Lötpunkten 45 (ball grid array) aufgelötet sein (Chip-on-Glass). Fig. 11b zeigt eine zu Fig. 11a analoge Ausführung ohne die Glasplatte 43 (bare die mit ball grid array). In Fig. 11c ist das Sensorelement 3 direkt auf der Leiterplatte 41 angeordnet. Fig. 11d und e zeigen alternative Draufsichten auf die Darstellung in Fig. 11c. Das Sensorelement 3 kann mit Hilfe von Bonddrähten 53 an der Leiterplatte 41 befestigt sein. Wie in Fig. 11d gezeigt, kann die optische Abschirm-Vorrichtung 1 mit einem "bare die", das heißt einem Halbleiterchip ohne Gehäuse kombiniert werden. Die optische Abschirm-Vorrichtung 1 richtet sich direkt an dem Sensorelement 3 sowohl vertikal als auch lateral aus und nutzt die Leiterplatte 41 zur Befestigung. Die zur Ausrichtung dienenden Kanten der Hard-Komponente 9 weisen gegebenenfalls Aussparungen für die in Fig. 11d und e dargestellten Bonddrähte 43 auf.

Besonders vorteilhaft sind Packaging-Technologien, die den Chip hermetisch versiegeln und mechanisch schützen (z.B. in der Chip-on-Glass-Ausführung) und gleichzeitig geringe Toleranzen zwischen Außenkanten und Chipposition aufweisen, wie z.B. in Fig. 11a dargestellt. Die Toleranzkette bei konventionellen Chip-Packages zur erfindungsgemäßen optischen Abschirm-Vorrichtung 1 setzt sich aus der Fertigungstoleranz der optischen Abschirm-Vorrichtung 1, der Toleranz des Sensorelements 3 (also des Chips- bzw. des Chip-Packages), welches typischerweise einem Mould-Package aus Keramik oder kostengünstigem Plastik entspricht, sowie der Toleranz der Chippositionierung innerhalb des Packages zusammen.

Die optische Abschirm-Vorrichtung 1 wird vorzugsweise mit Sensorelementen 3 kombiniert, die mit einem Packaging-Verfahren auf Wafer-Level hergestellt werden. Dabei sollen die Formtoleranzen des Sensorelements 3 deutlich geringer sein als bei einem Mould-Verfahren und entsprechen in etwa der Toleranz gesägter Dies.

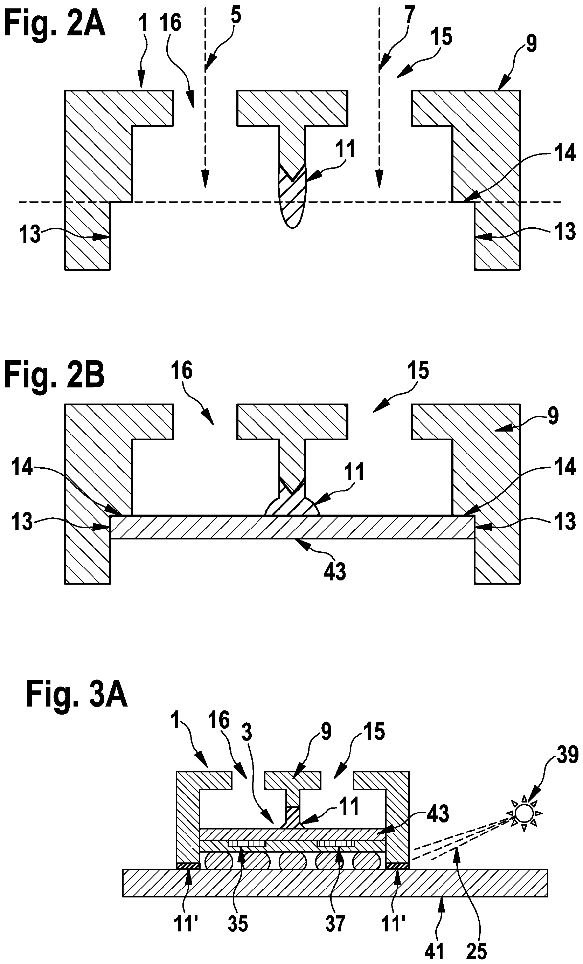

Wie in Fig. 1 gezeigt, weist die optische Abschirm-Vorrichtung 1 eine z.B. als weiche Lippe ausgeführte Soft-Komponente 11 und eine rahmenartige Hard-Komponente 9 auf. Die Soft-Komponente 11 liegt direkt auf der Sensorelementoberfläche 3 auf. Durch das weiche flexible Material schließt sie optisch dicht und trennt die Bereiche für Referenz- und Messstrahlung 7, 5. Dies kann z.B., wie in Fig. 2 dargestellt, dadurch erreicht werden, dass die nicht deformierte Soft-Komponente in Z-Richtung, also senkrecht auf einer Ebene parallel zur Oberfläche des Sensorelements 3, über die Auflageebene auf der Sensorelementoberfläche hinausragt. Die Soft-Komponente kann z.B. als parabolisch geformte Gummilippe realisiert sein, so dass sie auch bei Deformation eine definierte Anlagefläche bildet. Durch eine derartige Ausgestaltung der Soft-Komponente kann vermieden werden, dass sie z.B. bei Druckausübung zu einer Seite umklappt und eine nichtdefinierte Position auf der Sensorelementoberfläche einnimmt. Ferner weist die Hard-Komponente eine erste Anlagefläche 13 auf, die als seitlicher Anschlag ausgeführt ist und einer lateralen Ausrichtung der optischen Abschirm-Vorrichtung 1 am Sensorelement 3 dient. Des Weiteren weist optische Abschirm-Vorrichtung 1 eine zweite Anlagefläche 14 auf, die der Ausrichtung der optischen Abschirm-Vorrichtung 1 in einer Ebene senkrecht zur Oberfläche des Sensorelements 3 dient. Die zweite Anlagefläche 14 kann als Teil der Soft-Komponente 11 und/oder in der die Hard-Komponente 9 realisiert sein. Die optische Abschirm-Vorrichtung 1 weis eine erste Ausnehmung 16 für Messstrahlung 5 und eine zweite Ausnehmung 15 für Referenzstrahlung 7 auf.

In Fig. 2a ist die optische Abschirm-Vorrichtung 1 dargestellt. Die gestrichelte Linie stellt eine mögliche Ebene für die Position der Oberfläche des Sensorelements 3 dar. In Fig. 2b ist die optische Abschirm-Vorrichtung 1 auf ein Sensorelement 3 aufgesetzt, so dass eine Kraft auf die Soft-Komponente 11 ausgeübt wird und diese sich deformiert. Ferner richtet sich die optische Abschirm-Vorrichtung 1 an den ersten Anlageflächen 13 und den zweiten Anlageflächen 14 z.B. an der Glasplatte 43 aus.

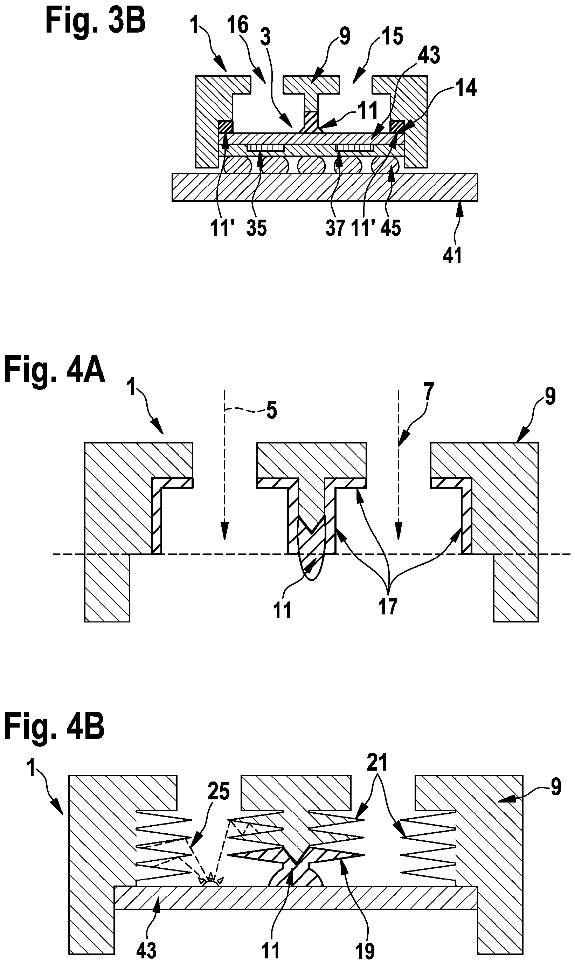

Wie in Fig. 3 dargestellt, können zusätzliche Soft-Elemente 11' an der optischen Abschirm-Vorrichtung 1 angeordnet sein. Diese können z.B., wie in Fig. 3a gezeigt, zwischen Leiterplatte 41 und der Hard-Komponente 9 angeordnet sein und einen optisch dichten Schluss mit der Leiterplatte 41 bewirken. Alternativ können, wie in Fig. 3b gezeigt, zusätzliche Soft-Elemente 11' zwischen der Hard-Komponente 9 und dem Sensorelement 3 z.B. oberhalb der Glasplatte 43 angeordnet sein und eine optische Abschirmung an den Seiten des Sensorelements ermöglichen. Insbesondere kann diese Anordnung ein optisches Übersprechen verhindern, wenn das Sensorelement 3 und eine Sendeeinrichtung 39, also eine Lichtquelle, nebeneinander auf der Leiterplatte 41 angeordnet sind. Zusätzlich können die Soft-Elemente 11' eine Ausrichtung der optischen Abschirm-Vorrichtung 1 in der z-Richtung unterstützen oder bewirken.

Wie in Fig. 4a gezeigt, kann die optische Abschirm-Vorrichtung 1 an der Sensorelement zugewandten Seite ein absorbierendes Material 17 sowohl an der Softals auch an der Hard-Komponente aufweisen. Zusätzlich oder alternativ kann die optische Abschirm-Vorrichtung 1 eine erste geometrische Struktur 19 der Soft-Komponente 11 und/oder eine zweite geometrische Struktur 21 der Hard-Komponente 9 aufweisen, die bewirken, dass Streulicht 25, wie z.B. von der Sensorelementoberfläche 3 reflektiertes Licht, in einer Lichtfalle absorbiert wird oder die optische Abschirm-Vorrichtung 1 wieder verlässt.

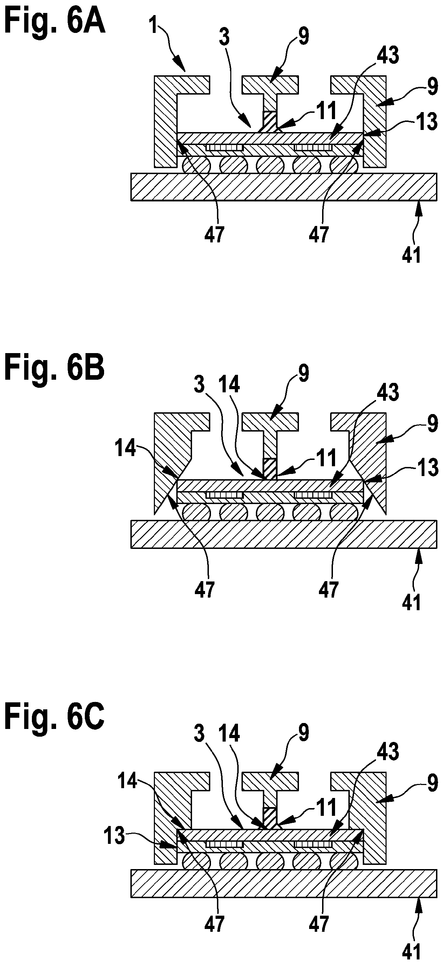

Die Hard-Komponente 9 kann ein hartes steifes Formteil sein, welches die Positionsgenauigkeit und mechanische Stabilität der optischen Abschirm-Vorrichtung 1 gewährleistet. Die Hard-Komponente 9 kann sich direkt formschlüssig in X- und Y-Richtung, also in der zur Sensorelementoberfläche parallelen Ebene, an dem Sensorelement 3 bzw. am Chip-Package ausrichten. Die Ausrichtung in der XY-Ebene ist in Fig. 6 mit dem Bezugszeichen 47 gekennzeichnet. Wie in Fig. 6a kann die erste Anlagefläche 13 hierfür als gerade Führung der Hard-Komponente 9 ausgeführt sein. Alternativ kann die Führung, wie in Fig. 6b, abgeschrägt ausgeführt sein. Zusätzlich kann, wie in Fig. 6c gezeigt, eine zweite Anlagefläche 14 die Ausrichtung unterstützen.

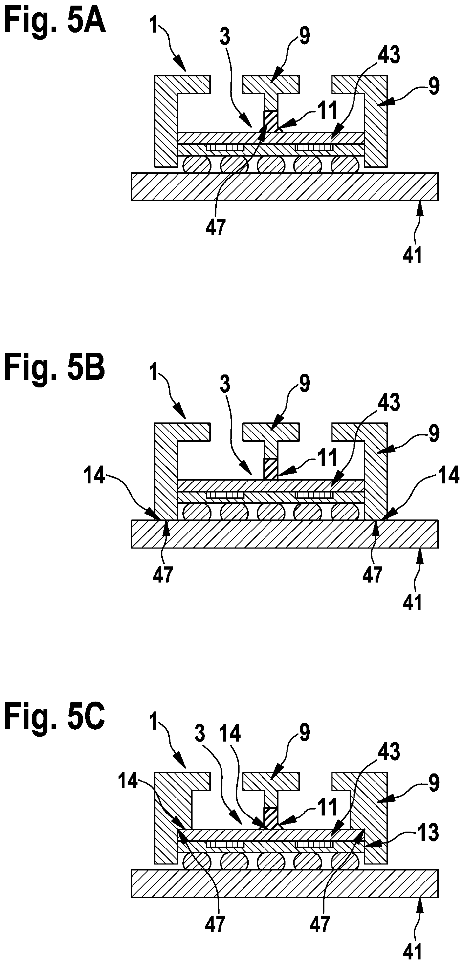

In Fig. 5 ist die Ausrichtung in der Z-Richtung senkrecht zur Sensorelementoberfläche dargestellt. Diese kann, wie in Fig. 5a mit dem Bezugszeichen 47 gekennzeichnet, mit Hilfe der zweiten Anlagefläche 14 der Soft-Komponente 11 an der Sensorelementoberfläche geschehen. Alternativ kann die Ausrichtung 47 wie in Fig. 5b in Z-Richtung formschlüssig mit der Leiterplatte 41 oder wie in Fig. 5c durch die zweite Anlagefläche 14 der Hard-Komponente an der Sensorelementoberfläche geschehen.

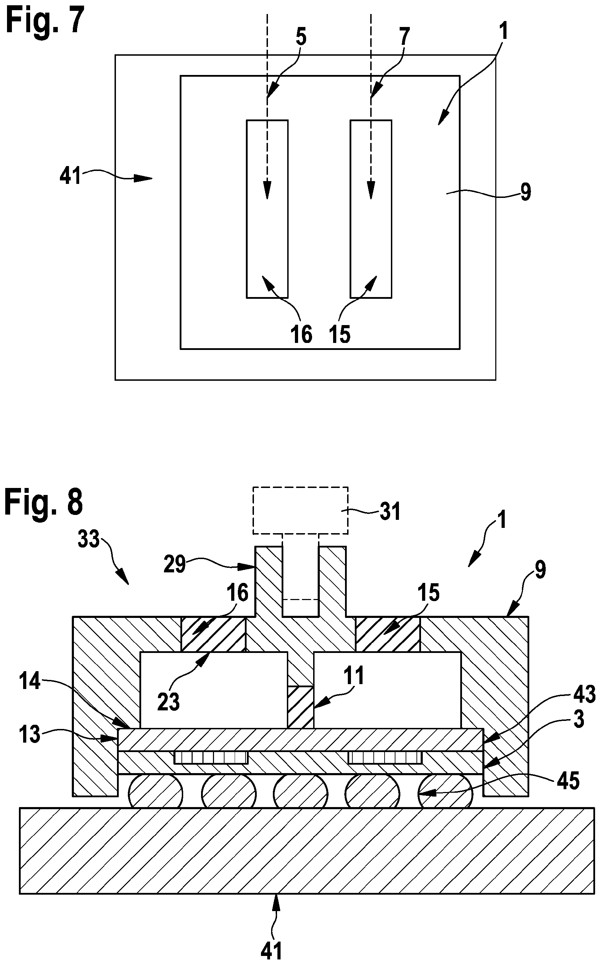

In Fig. 7 ist eine Draufsicht auf die optische Abschirm-Vorrichtung 1 dargestellt. Die Oberfläche der Hard-Komponente 9 weist eine erste Ausnehmung 16 und eine zweite Ausnehmung 15 auf, die jeweils zu jeder Seite der optischen Trennung für die Mess- und Referenzstrahlung 5, 7 angeordnet sind. Die Ausnehmungen 15,16 können offen, transparent verschlossen oder wie in Fig. 8 in einem optischen Filter 23 ausgeführt sein. Das jeweilige Material, aus welchem die Hard-und Soft-Komponente 9, 11 besteht, kann einen insbesondere in dem durch den optischen Einfallsfilter 23 transmittierten Wellenlängenbereich hohe Absorptionskoeffizienten aufweisen. Wie ferner in Fig. 8 dargestellt, kann die optische Abschirm-Vorrichtung 1 mit Aufsatzelementen 31 verbunden werden, die ebenfalls der Trennung von Referenz- und Messstrahlung 7, 5 dienen. Hierzu kann an einer Oberseite der optischen Abschirm-Vorrichtung 1 ein Schnittstellenelement 29, z.B. ausgeführt als Adapter, vorgesehen sein, das eine Verbindung, z.B. Kleben oder Stecken, mit Toleranzen erlaubt, die deutlich über der erforderlichen Positioniergenauigkeit der Soft-Komponente 11 auf dem Chip liegen.

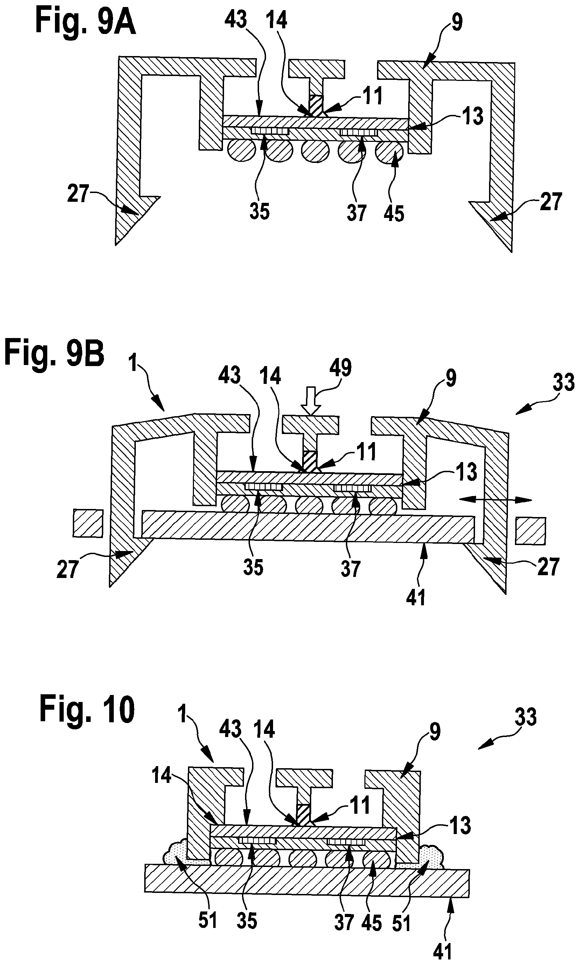

Die mechanische Fixierung der optischen Abschirm-Vorrichtung 1 ist in den Fig. 9 und 10 dargestellt. Die Hard-Komponente 9 kann z.B., wie in Fig. 10 gezeigt, mit dem Trägerelement 41 und dem Sensorelement 3 mittels Verklebung 51 befestigt werden. Der Kleber 51 in kann ähnlich der Softkomponente 11' in Fig. 3A optisch undurchlässig sein und in gleicher Weise den Einfall von Streulicht verhindern.

In Fig. 9 ist die Fixierung mittels Befestigungselementen 27, die als Schnapphaken ausgeführt sind, dargestellt. Diese ermöglichen dank ihrer Federwirkung, dass die optische Abschirm-Vorrichtung 1 mit optimiertem Anpressdruck auf dem Sensorelement 3 aufliegt und bewirken so einen Formschluss der Sensorelementoberfläche mit der Soft-Komponente 11. Die Kraft auf die Sensoroberfläche ist mit dem Bezugszeichen 49 dargestellt. Wegen der typischen Materialstärken von Kunststoffteilen und typischen Abmessungen von Befestigungselementen 27, die z.B. als Schnapphaken, Verklebungen, Heißverstemmungen und Ultraschallverschweißungen ausgeführt sein können, kann eine Befestigung bzw. Fixierung am Chip-tragenden Element, also z.B. an der Leiterplatte 41, empfehlenswert sein. Durch die Ausrichtung der Abschirm-Vorrichtung 1 direkt an dem Sensorelement 3 übertragen sich hohe Formtoleranzen der Leiterplatte 41 nicht.

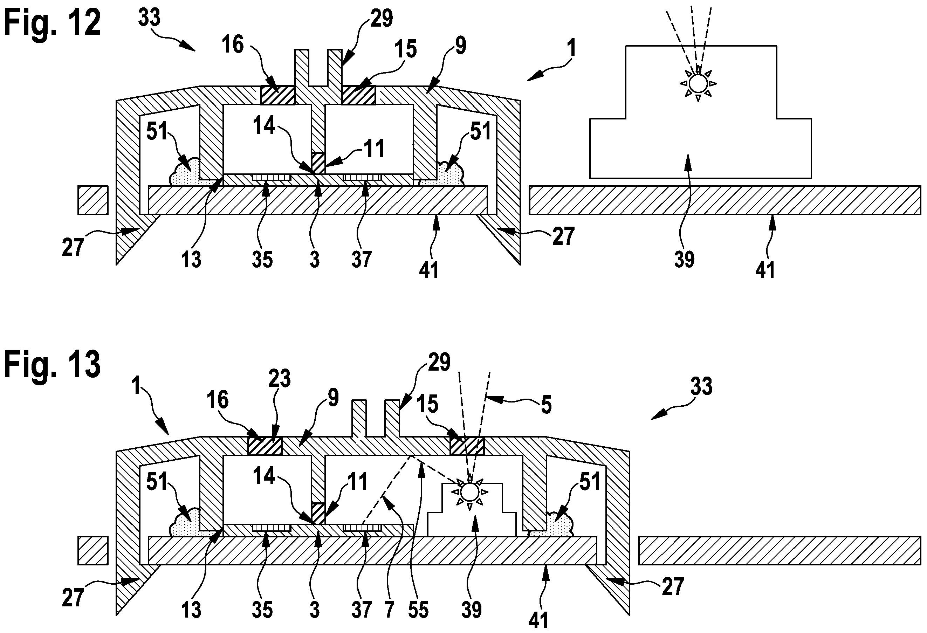

In den Fig. 12 und 13 sind Sensoreinheiten 33 dargestellt, die sowohl Verklebungen 51 als auch Befestigungselemente 27 aufweisen. In Fig. 12 ist eine Sendeeinrichtung 39 ausgeführt als Laserdiode neben der Sensoreinheit 33 auf der Leiterplatte 41 angeordnet. In Fig. 13 ist die Lichtquelle 39 in die Sensoreinheit 33 integriert. Messstrahlung 5 kann die Sensoreinheit 33 durch die zweite Ausnehmung 15 verlassen und durch die erste Ausnehmung 16 den ersten Detektionsbereich 35 des Sensorelements 3 erreichen. Die Referenzstrahlung 7 kann entlang einer Sensoreinheit-internen Referenzstrecke 55 verlaufen, indem sie z.B. von der Sensorelement zugewandten Seite der Hard-Komponente 9 auf den zweiten Detektionsbereich 37 des Sensorelements 3 z.B. durch Reflektion umgelenkt wird.

## Patentansprüche

1. Sensoreinheit (33) zum Detektieren von Referenz- und Messstrahlung (7, 5) für ein Entfernungsmessgerät, die Sensoreinheit (33) aufweisend
ein Sensorelement (3) und ferner eine optische Abschirm-Vorrichtung (1);
**dadurch gekennzeichnet, dass** das Sensorelement (3) einen ersten Detektionsbereich (35) zum Detektieren von Messstrahlung (5) und einen zweiten Detektionsbereich (37) zum Detektieren von Referenzstrahlung (7) aufweist;
wobei die optische Abschirm-Vorrichtung (1) den ersten und den zweiten Detektionsbereich (35, 37) optisch voneinander trennt;
wobei die optische Abschirm-Vorrichtung (1) in Bezug auf das Sensorelement positioniert und fixiert ist;
wobei die optische Abschirm-Vorrichtung (1) eine erste Ausnehmung (16) und eine zweite Ausnehmung (15) aufweist, die durchlässig für die optische Strahlung eines ersten Wellenlängenbereichs sind.

2. Sensoreinheit (33) gemäß Anspruch 1,
wobei die optische Abschirm-Vorrichtung (1) eine erste Anlagefläche (13) aufweist, die ausgestaltet ist, eine Ausrichtung der optischen Abschirm-Vorrichtung (1) in einer Ebene parallel zur Oberfläche des Sensorelements (3) zu bewirken.

3. Sensoreinheit (33) gemäß einem der Ansprüche 1 und 2,
wobei die optische Abschirm-Vorrichtung (1) eine zweite Anlagefläche (14) aufweist, die ausgestaltet ist, eine Ausrichtung der optischen Abschirm-Vorrichtung (1) in einer Ebene senkrecht zur Oberfläche des Sensorelements (3) zu bewirken.

4. Sensoreinheit (33) gemäß einem der Ansprüche 1 bis 3,
wobei die optische Abschirm-Vorrichtung (1) eine Hard-Komponente (9) und
eine Soft-Komponente (11) aufweist;
wobei die Hard- und die Softkomponente (9, 11) undurchlässig für optische Strahlung des ersten Wellenlängenbereichs sind;
wobei die Soft-Komponente (11) an einer sensorzugewandten Seite der optischen Abschirm-Vorrichtung (1) angeordnet und deformierbar ausgeführt ist.

5. Sensoreinheit (33) gemäß Anspruch 4,
wobei die Soft-Komponente (11) in einem nicht deformierten Zustand in einer zum Sensorelement (3) senkrechten Ebene eine zweite Anlagefläche (14) der Hard-Komponente (9) in Richtung Sensorelement (3) überragt.

6. Sensoreinheit (33) gemäß einem der Ansprüche 4 bis 5,
wobei die Soft-Komponente (11) ein im ersten Wellenlängenbereich absorbierendes Material aufweist;
wobei die Hard-Komponente (9) ein im ersten Wellenlängenbereich absorbierendes Material aufweist.

7. Sensoreinheit (33) gemäß einem der Ansprüche 4 bis 6,
wobei die Soft-Komponente (11) eine erste geometrische Struktur (19) aufweist, die ausgeführt ist, Streustrahlung (25) von einer Sensoroberfläche abzulenken;
wobei die Hard-Komponente (9) eine zweite geometrische Struktur (21) aufweist, die ausgeführt ist, Streustrahlung (25) von der Sensoroberfläche abzulenken.

8. Sensoreinheit (33) gemäß einem der Ansprüche 4 bis 7,
wobei die Soft-Komponente (11) einstückig mit der Hard-Komponente (9) ausgeführt ist.

9. Sensoreinheit (33) gemäß einem der Ansprüche 1 bis 8, ferner aufweisend ein Trägerelement (41);
wobei das Sensorelement (3) an dem Trägerelement (41) fixiert ist;
wobei an der optischen Abschirm-Vorrichtung (1) ferner ein Befestigungselement (27) angeordnet ist;
wobei das Befestigungselement (27) ausgestaltet ist, derart mit dem Trägerelement (41) einzugreifen, dass eine formschlüssige Verbindung zwischen einer Oberfläche des Sensorelements (3) und der optischen Abschirm-Vorrichtung (1) entsteht.

10. Sensoreinheit (33) gemäß einem der Ansprüche 1 bis 9, ferner aufweisend ein Schnittstellenelement (29);
wobei das Schnittstellenelement (29) ausgestaltet ist, ein Aufsatzelement (31) mit der optischen Abschirm-Vorrichtung (1) zu verbinden.

11. Sensoreinheit (33) gemäß einem der Ansprüche 1 bis 10, ferner aufweisend eine Sendeeinrichtung (39) zum Aussenden von Messstrahlung (5) und Referenzstrahlung (7);
wobei die Sendeeinrichtung (39) innerhalb der Sensoreinheit (33) angeordnet ist.

12. Entfernungsmessgerät zum Bestimmen einer Entfernung, das Entfernungsmessgerät aufweisend
eine Sensoreinheit (33) gemäß Anspruch 11.

## Claims

1. Sensor unit (33) for detecting reference and measurement radiation (7, 5) for a distance measuring apparatus, the sensor unit (33) comprising
a sensor element (3) and furthermore an optical shielding device (1);
**characterized in that** the sensor element (3) has a first detection region (35) for detecting measurement radiation (5) and a second detection region (37) for detecting reference radiation (7);
wherein the optical shielding device (1) optically isolates the first and second detection regions (35, 37) from one another;
wherein the optical shielding device (1) is positioned and fixed with respect to the sensor element;
wherein the optical shielding device (1) has a first cutout (16) and a second cutout (15), which are transmissive to the optical radiation in a first wavelength range.

2. Sensor unit (33) according to Claim 1, wherein the optical shielding device (1) has a first bearing surface (13), which is designed to bring about an orientation of the optical shielding device (1) in a plane parallel to the surface of the sensor element (3) .

3. Sensor unit (33) according to either of Claims 1 and 2,
wherein the optical shielding device (1) has a second bearing surface (14), which is designed to bring about an orientation of the optical shielding device (1) in a plane perpendicular to the surface of the sensor element (3).

4. Sensor unit (33) according to any of Claims 1 to 3,
wherein the optical shielding device (1) has a hard component (9) and a soft component (11);
wherein the hard and soft components (9, 11) are opaque to optical radiation in the first wavelength range; wherein the soft component (11) is arranged and embodied in a deformable fashion on a sensor-facing side of the optical shielding device (1).

5. Sensor unit (33) according to Claim 4,
wherein the soft component (11) in a non-deformed state, in a plane perpendicular to the sensor element (3), projects beyond a second bearing surface (14) of the hard component (9) in the direction of the sensor element (3).

6. Sensor unit (33) according to either of Claims 4 and 5,
wherein the soft component (11) comprises a material which is absorbent in the first wavelength range; wherein the hard component (9) comprises a material which is absorbent in the first wavelength range.

7. Sensor unit (33) according to any of Claims 4 to 6,
wherein the soft component (11) has a first geometrical structure (19), which is embodied for deflecting stray radiation (25) from a sensor surface;
wherein the hard component (9) has a second geometrical structure (21) which is embodied for deflecting stray radiation (25) from the sensor surface.

8. Sensor unit (33) according to any of Claims 4 to 7,
wherein the soft component (11) is embodied integrally with the hard component (9).

9. Sensor unit (33) according to any of Claims 1 to 8, furthermore comprising
a carrier element (41);
wherein the sensor element (3) is fixed to the carrier element (41);
wherein a securing element (27) is furthermore arranged on the optical shielding device (1);
wherein the securing element (27) is designed to engage with the carrier element (41) in such a way that a positively locking connection arises between a surface of the sensor element (3) and the optical shielding device (1).

10. Sensor unit (33) according to any of Claims 1 to 9, furthermore comprising
an interface element (29);
wherein the interface element (29) is designed to connect an attachment element (31) to the optical shielding device (1).

11. Sensor unit (33) according to any of Claims 1 to 10, furthermore comprising
a transmitting device (39) for emitting measurement radiation (5) and reference radiation (7);
wherein the transmitting device (39) is arranged within the sensor unit (33).

12. Distance measuring apparatus for determining a distance, the distance measuring apparatus comprising a sensor unit (33) according to Claim 11.

## Revendications

1. Unité à capteur (33) pour la détection de rayonnements de référence et de mesure (7, 5) pour un télémètre, l'unité à capteur (33) comportant un élément capteur (3) ainsi qu'un dispositif d'écran optique (1) ;
**caractérisée en ce que** l'élément capteur (3) comporte une première zone de détection (35) pour la détection d'un rayonnement de mesure (5) et une seconde zone de détection (37) pour la détection d'un rayonnement de référence (7) ;
dans laquelle le dispositif d'écran optique (1) sépare optiquement les première et seconde zones de détection (35, 37) ;
dans laquelle le dispositif d'écran optique (1) est positionné et fixé par rapport à l'élément capteur ; dans laquelle le dispositif d'écran optique (1) présente un premier évidement (16) et un second évidement (15) qui laissent passer le rayonnement optique d'une première plage de longueurs d'onde.

2. Unité à capteur (33) selon la revendication 1, dans laquelle le dispositif d'écran optique (1) présente une première surface d'appui (13) conçue pour provoquer une orientation du dispositif d'écran optique (1) dans un plan parallèle à la surface de l'élément capteur (3).

3. Unité à capteur (33) selon l'une des revendications 1 et 2,
dans laquelle le dispositif d'écran optique (1) présente une seconde surface d'appui (14) conçue pour provoquer une orientation du dispositif d'écran optique (1) dans un plan perpendiculaire à la surface de l'élément capteur (3).

4. Unité à capteur (33) selon l'une des revendications 1 à 3,
dans laquelle le dispositif d'écran optique (1) comprend un composant dur (9) et un composant mou (11) ;
dans laquelle les composants dur et mou (9, 11) sont opaques au rayonnement optique de la première plage de longueurs d'onde ;
dans laquelle le composant mou (11) est disposé sur un côté tourné vers le capteur du dispositif d'écran optique (1) et est déformable.

5. Unité à capteur (33) selon la revendication 4,
dans laquelle le composant mou (11) à l'état non déformé dans un plan perpendiculaire à l'élément capteur (3) fait saillie par rapport à une seconde surface d'appui (14) du composant matériel (9) dans la direction de l'élément capteur (3).

6. Unité à capteur (33) selon l'une des revendications 4 à 5,
dans laquelle le composant mou (11) comprend un matériau absorbant dans la première plage de longueurs d'onde ;
dans laquelle le composant dur (9) comprend un matériau absorbant dans la première plage de longueurs d'onde.

7. Unité de capteur (33) selon l'une des revendications 4 à 6,
dans laquelle le composant mou (11) présente une première structure géométrique (19) conçue pour dévier le rayonnement diffusé (25) par une surface de capteur ;
dans laquelle le composant dur (9) présente une seconde structure géométrique (21) conçue pour dévier le rayonnement diffusé (25) par la surface de capteur.

8. Unité de capteur (33) selon l'une des revendications 4 à 7,
dans laquelle le composant mou (11) est réalisé d'un seul tenant avec le composant dur (9).

9. Unité à capteur (33) selon l'une des revendications 1 à 8, comportant en outre un élément de support (41) ;
dans laquelle l'élément capteur (3) est fixé à l'élément de support (41) ;
dans laquelle un élément de fixation (27) est en outre disposé sur le dispositif d'écran optique (1) ;
dans laquelle l'élément de fixation (27) est conçu pour s'engager dans l'élément de support (41) de manière à établir une liaison par complémentarité de forme entre une surface de l'élément capteur (3) et le dispositif d'écran optique (1).

10. Unité à capteur (33) selon l'une des revendications 1 à 9, comportant en outre un élément d'interface (29) ;
dans laquelle l'élément d'interface (29) est conçu pour relier un élément de montage (31) au dispositif d'écran optique (1).

11. Unité à capteur (33) selon l'une des revendications 1 à 10, comportant en outre un dispositif d'émission (39) destiné à émettre un rayonnement de mesure (5) et un rayonnement de référence (7) ;
dans laquelle le dispositif d'émission (39) est disposé à l'intérieur de l'unité à capteur (33).

12. Appareil de mesure de distance destiné à déterminer une distance, l'appareil de mesure de distance comportant une unité à capteur (33) selon la revendication 11.
